# EUROPEAN PATENT APPLICATION

(11) **EP 4 707 994 A1**
(43) Date of publication of application: **11.03.2026**
(21) Application number: 25197483.8
(22) Date of filing: 21.08.2025
(51) Int. Cl.: G06F 1/20, H05K 7/20

(54) **ENGINEERING SERVER RACK RETURN TEMPERATURE RESPONSE TIME VIA LIQUID COOLING**

(30) Priority: 23.08.2024 US 202463686296 P; 19.08.2025 US 202519303661
(71) Applicant: Vertiv Corporation, Westerville, OH 43082 (US)
(72) Inventor: SALEH, Adam Mustafa, Westerville, 43082 (US); KING, Jeremy Ryan, Westerville, 43082 (US)
(74) Representative: Bryn-Jacobsen, Caelia

(57) **Abstract**

Systems and methods for mitigating temperature excursion for IT equipment within a data center using a liquid cooling system are disclosed. A supply temperature control routine to a server rack is configured to alert a coolant distribution unit and a heat rejection plant when the temperature of a given server rack is reaching a critical temperature, due to increased demand of the computing resources within the server rack. Using a temperature sensor that is located at the server rack, the computing device controller is configured to receive up-to-date temperature readings. Thus, the computing device controller is able to locally monitor return temperature of the server rack and provide alerts to the coolant system when needed.

## Description

### CROSS-REFERENCE TO RELATED APPLICATIONS

This U.S. Non-Provisional Patent Application that claims the benefit of and priority to U.S. Provisional Patent Application No. 63/686,296 filed August 23, 2024, and U.S. Patent Application No. 19/303,661, filed August 19, 2025.

### TECHNICAL FIELD

The present disclosure relates to systems and methods for cooling computing systems, such as computing systems on the scale of rack servers within data centers.

### BACKGROUND

Data centers are susceptible to temperature excursion when a cooling system does not match the maximum computing power, and thus excess heat, that may be generated when a large amount of the total computing resources in the data center are simultaneously in use. Past attempts to mitigate such problems tended to be simply reactive, and are not robust against a sudden and steep change in computing resource usage.

### SUMMARY

The present disclosure relates to managing a cooling system for computing resources within server enclosures. By tracking return water temperature at an outlet of a given server enclosure, a computing device controller is configured to limit temperature excursion by proactively signaling to a coolant distribution unit and to a heat rejection plant to begin ramping up, in preparation for cooling the computing resources within the given server enclosure.

In some examples, the present disclosure includes a cooling system for a data center. The cooling system includes: a coolant distribution unit, configured to cycle a coolant to an inlet of a server enclosure; a heat rejection plant, configured to cycle the coolant to the coolant distribution unit; the server enclosure, comprising a plurality of computing resources; a temperature sensor, located at an outlet of the server enclosure, and configured to periodically perform a temperature reading at the outlet of the server enclosure; and a computing device controller configured to: receive the temperature readings from the temperature sensor; detect that a recent temperature reading is outside of a temperature range allocated for the server enclosure; provide a first alert to the coolant distribution unit; and cause the heat rejection plant to begin a ramp up sequence.

The present disclosure also includes methods for cooling computing resources within server enclosures, which includes: receiving temperature readings from a temperature sensor that is located at an outlet of a server enclosure; determining, based on a given one of the temperature readings, that temperature at the outlet of the server enclosure is outside of a temperature range allocated for the server enclosure; sending a first alert to a coolant distribution unit to open valves to an updated position with respect to a previous position of the valves; and sending a second alert to a heat rejection plant to begin a ramp up sequence to provide coolant to the coolant distribution unit.

### BRIEF DESCRIPTION OF THE DRAWINGS

FIG. 1 illustrates a cooling system that is configured to monitor temperature at an outlet of a server rack and proactively mitigate a temperature excursion for the server rack, according to some examples.
FIG. 2A is a flow diagram that illustrates a process of operating a cooling system for a data center when a significant use of a given server rack commences, wherein the process is described largely from a perspective of a coolant distribution unit, according to some examples.
FIG. 2B follows a similar flow diagram to that which was introduced in FIG. 2A, and provides example time increments that are applied during the process, according to some examples.
FIG. 3A is a flow diagram that illustrates a process of operating a cooling system for a data center when a significant use of a given server rack commences, wherein the process is described largely from a perspective of a heat rejection plant, according to some examples.
FIG. 3B follows a similar flow diagram to that which was introduced in FIG. 3A, and provides example time increments that are applied during the process, according to some examples.
FIG. 4 is a schematic of a coolant distribution unit, according to some examples.
FIG. 5 illustrates inlet and outlet water temperatures from a perspective of a coolant distribution unit, according to some examples.

### DETAILED DESCRIPTION

As direct-to-chip technology is rapidly developing (e.g., to accommodate complex processing technologies, such as artificial intelligence (AI) and machine learning (ML) data clusters), protecting the health of servers and improving the confidence of cooling systems is critical. Thus, the systems and methods described herein pertain to implementing improved supply temperature response time controls.

The need for sustained and reliable computing power is ever increasing, and in advanced computing domains, such as in ML and AI, certain workloads may require a ramp from 0 to 100% in less than a second. Thus, data centers that are designed to provide such computing power require equally reliable cooling systems to ensure that the computing resources within the data center do not overheat and shutdown.

Previous and ineffective methods of mitigating this issue included either permanently maintaining valves of the coolant distribution units at fully open positions, and/or attempting to bring a heat rejection plant online after sensing an increasing water temperature from a temperature sensor located at the coolant distribution units. Either previously used method leads to a reduction in the overall efficiency of the data center. Moreover, and continuing with the above example of a ramp from 0 to 100% in less than a second, such a dramatic change in load may trigger a large excursion in supply temperature to the computing resources in the server rack. If the excursion in supply temperature exceeds the maximum allowable temperature to the information technology (IT) equipment, the IT equipment may become damaged, and/or may shutdown, thus interrupting the execution of ongoing ML or AI workloads.

As opposed to attempting to prevent the temperature excursion using one or more of the above ineffective methods, the present disclosure proactively treats this issue, thus drastically increasing the overall efficiency of the data center.

By implementing a routine to manage and control a cooling system for the data center using respective temperature sensors that are located at corresponding outlets of the server enclosures, a coolant distribution unit (CDU) is alerted of higher incoming temperatures much sooner than if the temperature sensor were located at the CDU. By alerting the CDU of an increase of rack return temperature that is outside of a functional range, the system is configured to respond quicker, and proactively, in order to mitigate the severity the temperature excursion that may occur from a 0 to 100% load change, for example. The smaller excursion, with respect to the previous and ineffective retroactive methods that would have resulted in a substantially larger excursion, allows for a higher IT equipment temperature set point, making the overall data center more efficient in mitigating problems associated with overheating of computing resources. Being able operate the data center more efficiently by having a higher IT equipment temperature set point also saves a significant amount of energy, reducing the annual cost of electricity that is required to operate the data center.

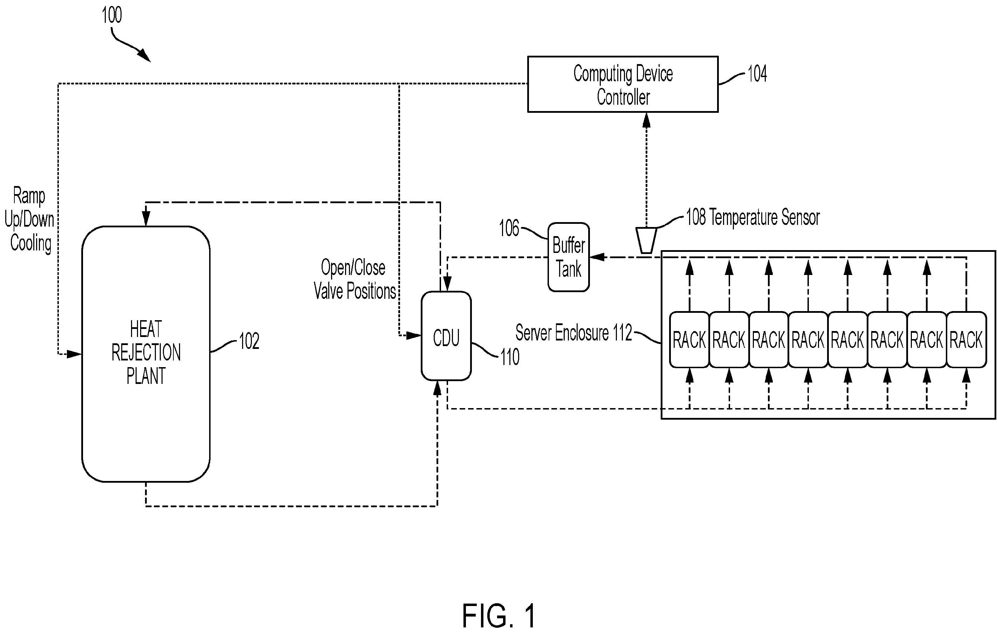

FIG. 1 illustrates a cooling system that is configured to monitor temperature at an outlet of a server rack and proactively mitigate a temperature excursion for the server rack, according to some examples.

The systems and methods described herein are configured to be proactive towards dissipation of heat in such a data center environment, rather than being simply reactive. In order to prevent unwanted shutdown of any of the computing resources that are susceptible to overheating in such circumstances, the cooling system is configured to prepare for substantial and significant ramp in computing resource usage, in order to mitigate temperature excursion in a data center environment.

As illustrated in a cooling system 100, computing resources are housed within a server enclosure 112, and are configured to be used for execution of large-scale algorithms, such as ML and AI based models. The given illustration in FIG. 1 shows eight server racks that are supplied by a single CDU 110 and a heat rejection plant 102. However, the illustrated diagram is not meant to be restrictive, and it should be understood that more or less computing resources may be housed within the server enclosure 112. In addition, the cooling system 100, as illustrated in FIG. 1, may refer to a portion of a larger data center not shown in the figure. Particular examples shown in FIG. 1 are thus meant for ease of discussion herein, and are not meant to restrict the scale to which the methods and systems described herein may be used for.

As used herein, computing resources may refer to any number of computing elements that are housed within a server rack scale (e.g., the server enclosure 112 may house a plurality of servers, etc.).

As additionally shown in FIG. 1, a temperature sensor 108 is located at an outlet of the server enclosure 112, and is configured to take temperature measurements of water at the outlet of the server racks. The computing device controller 104 is then configured to periodically poll the temperature sensor 108 for the temperature readings, according to some examples. The computing device controller 104 is further configured to store information pertaining to acceptable temperatures that the server enclosure 112, and the computing resources inside, are configured to operate at. For example, the server enclosure 112 may be graded to operate between a first and a second temperature. In another example, the server enclosure 112 may be configured to operate at any temperature below a given maximum temperature. There may be additional metadata related to operational temperatures, such as a first range of temperatures that the rack of servers is typically and/or ideally configured to function within and a second range of temperatures that the rack of servers may still operate at but less efficiently, etc.

In some examples, the computing device controller 104 may be locally connected to the temperature sensor 108. In other examples, the computing device controller 104 may be remotely connected to the temperature sensor 108, as long as there is not a substantial delay in receiving temperature measurements from the temperature sensor 108 (e.g., the received signals from the temperature sensor 108 should be close to real-time).

The computing device controller 104 is then configured to monitor the temperature readings of the outlet of the server enclosure 112. In some examples, when computing device controller 104 detects that the outlet of server enclosure 112 has risen above a certain threshold, e.g., risen to a temperature beyond a range of acceptable temperatures that the server enclosure 112 and the computing resources inside are configured to operate within and that have been stored by the computing device controller 104 for reference, it sends a first alert to the CDU 110 and a second alert to the heat rejection plant 102. As introduced above, the computing device controller 104 may be configured to compare a given temperature reading to stored information pertaining to the range of acceptable temperatures that the server enclosure 112 and the computing resources inside are configured to operate within, and determine that the given temperature reading is outside of that range.

The first alert provides an indication to the CDU 110 that a substantial IT load has begun at the server enclosure 112, and may provide further instructions such as an indication to open valves within the CDU 110 to a more opened position than they are fixed at currently. The second alert directs the heat rejection plant 102 to begin a ramp up sequence, in order to start providing coolant to the CDU 110, which then provides the coolant to the inlet of the server enclosure 112.

Furthermore, the computing device controller 104 will then continue to monitor the temperature readings of the outlet of server enclosure 112 and continue to provide further instructions to the CDU 110 and/or to the heat rejection plant 102. For example, the computing device controller 104 may detect that the temperature readings of the temperature sensor 108 are still increasing, and therefore may send an additional alert to the CDU 110 in order to fix the valves at a fully open configuration. In another example, the computing device controller 104 may detect that the temperature readings of the temperature sensor 108 have stabilized at an elevated temperature, and thus the current configuration of the valves of the CDU 110 are to be maintained. In yet another example, the computing device controller 104 may detect that the temperature readings of the temperature sensor 108 are trending downwards towards being within the acceptable range of temperatures for the server enclosure 112, and thus may instruct the heat rejection plant 102 to begin ramping back down and/or may instruct the CDU 110 to begin to close back the valves to their original configuration (e.g., the configuration before the substantial IT load was detected).

In some configurations of the cooling system 100 of a given data center, a buffer tank 106 may also be installed in between the outlet of the server enclosure 112 and the CDU 110. If a particularly large amount of servers are enclosed within the server enclosure 112, and/or a particularly rapid usage of a large amount of servers within the server enclosure 112 is expected to occur frequently within the given data center configuration, then the buffer tank may be installed in order to delay hot water being cycled from the outlet of the server enclosure, through the CDU 110, and back to the inlet of the server enclosure.

In some examples, the buffer tank 106 is a tank that is configured to provide increased thermal inertia and CDU system volume (e.g., the buffer tank may be configured for 1,000 liters, or some other capacity). By providing extra capacity to the CDU 110, the buffer tank 106 reduces the frequency of compressor starts and diminishes the operation issues associated with drastic load variations (e.g., ramping zero to 100% in less than one second). The buffer tank 106 may be built from a metal and may be coated with an anti-condensate insulation. Moreover, the buffer tank 106 and temperature sensor 108 may be located within the CDU 110, according to some examples.

In some examples, the heat rejection plant 102 may include chillers, dry coolers, or one or more cooling towers.

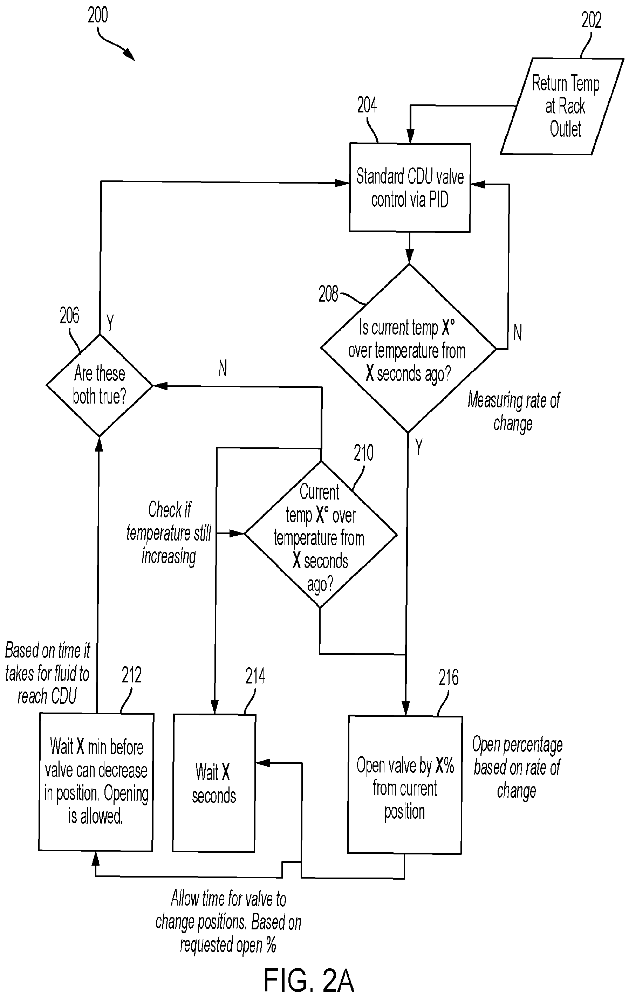

FIG. 2A is a flow diagram that illustrates a process 200 of operating the cooling system 100 for a data center when a significant use of a given server rack commences, wherein the process is described largely from a perspective of the coolant distribution unit 110, according to some examples.

In block 202, return temperature readings, measured by the temperature sensor 108 that is located at the outlet of the server enclosure 112, are provided to the computing device controller 104 in response to polling requests from the computing device controller 104.

In block 204, the computing device controller 104 polls the temperature sensor 108 that is located at the outlet of the server enclosure 112 for an updated temperature reading. In some examples, the computing device controller 104 may be locally connected to the CDU 110, as illustrated in FIG. 1.

In block 202, a return temperature reading, measured by the temperature sensor 108 that is located at the outlet of the server enclosure 112, is provided to the computing device controller 104.

In block 208, the computing device controller 104 determines whether or not the recent temperature reading reflects an elevated temperature or not. If the temperature reading is not above a given threshold, or is not elevated by a certain amount with respect to a previous temperature reading, then the computing device controller 104 continues to poll the temperature sensor for new temperature readings. If the temperature reading is above a given threshold, or is elevated by a certain amount with respect to a previous temperature reading, then the computing device controller 104 provides instructions, as illustrated in block 216, to the CDU 110 to open valves by *X%* with respect to their previous positions, e.g., *Y%.* For example, the previous positions of the valves may be at a 10% valve opening position, and a 5°C increase in temperature reading may cause the valves to be opened 50% more with respect to the original position (e.g., *X%* = 60% valve opening position). This instruction to open the valves by *X%* as opposed to Z%, etc. is determined based on a rate of change between previous temperature readings and the most recently received temperature reading.

In block 214, the computing device controller 104 indicates that a certain amount of time must pass before further action is taken in order to allow for the valves to complete their change in configuration. In some examples, the amount of time may range between 5 and 90 seconds, depending upon given configurations of the data center. In the meantime, the computing device controller 104 continues to poll for new temperature readings, as indicated in block 210. If the new temperature reading is elevated by a certain amount with respect to past temperature readings, then the computing device controller 104 may provide another set of instructions to the CDU 110 to open the valves even further with respect to the previous instruction of *X%.* This loop may continue, as illustrated in FIG. 2A. If, however, the new temperature reading is not elevated with respect to the past temperature readings, the computing device controller 104 may deduce that the temperature at the outlet of the server enclosure 112 has stabilized at an elevated temperature, and proceed to block 212.

In block 212, the computing device controller 104 again indicates that a certain amount of time must pass before further action is taken. If, after the given passage of time, the temperature has not continued to increase, as indicated by block 206, the computing device controller 104 may then provide yet another set of instructions to the CDU 110 to begin reverting the valves back to their original configuration (e.g., close the valves by *X*%)*.*

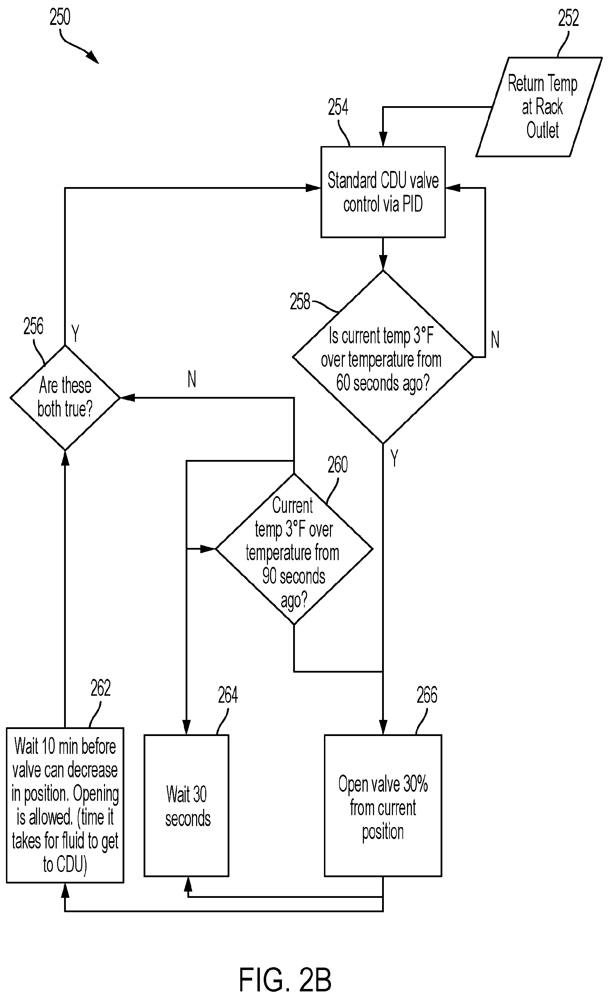

FIG. 2B follows a similar flow diagram to that which was introduced in FIG. 2A, and provides example time increments that are applied during a process 250, according to some examples.

In block 252, return temperature readings, measured by the temperature sensor 108 that is located at the outlet of the server enclosure 112, are provided to the computing device controller 104 in response to polling requests from the computing device controller.

In block 254, the computing device controller 104 polls the temperature sensor 108 that is located at the outlet of the server enclosure 112 for an updated temperature reading. In some examples, the computing device controller 104 may be locally connected to the CDU110 , as illustrated in FIG. 1.

In block 252, a return temperature reading, measured by the temperature sensor 108 that is located at the outlet of the server enclosure 112, is provided to the computing device controller 104.

In block 258, the computing device controller 104 determines whether or not the recent temperature reading reflects an elevated temperature of 3°F higher than sixty seconds ago or not. If the temperature reading is not 3°F higher than sixty seconds ago, then the computing device controller 104 continues to poll the temperature sensor 108 for new temperature readings. If the temperature reading is at least 3°F higher than sixty seconds ago, then the computing device controller 104 provides instructions, as illustrated in block 266, to the CDU 110 to open valves by 30% with respect to their previous positions.

In block 264, the computing device controller 104 indicates that 30 seconds must then pass before further action is taken. In the meantime, the computing device controller 104 continues to poll for new temperature readings, as indicated in block 260. If the new temperature reading is elevated by 3°F higher than ninety seconds ago, then the computing device controller 104 may provide another set of instructions to the CDU 110 to open the valves even further with respect to the previous instruction of 30%. This loop may continue, as illustrated in FIG. 2B. If, however, the new temperature reading is not elevated with respect to the past temperature readings, the computing device controller 104 may deduce that the temperature at the outlet of the server enclosure 112 has stabilized at an elevated temperature, and proceed to block 262.

In block 262, the computing device controller 104 again indicates that ten minutes must pass before further action is taken. If, after the ten minutes, the temperature has not continued to increase, as indicated by block 256, the computing device controller 104 may then provide yet another set of instructions to the CDU 110 to begin reverting the valves back to their original configuration (e.g., close the valves by 30%).

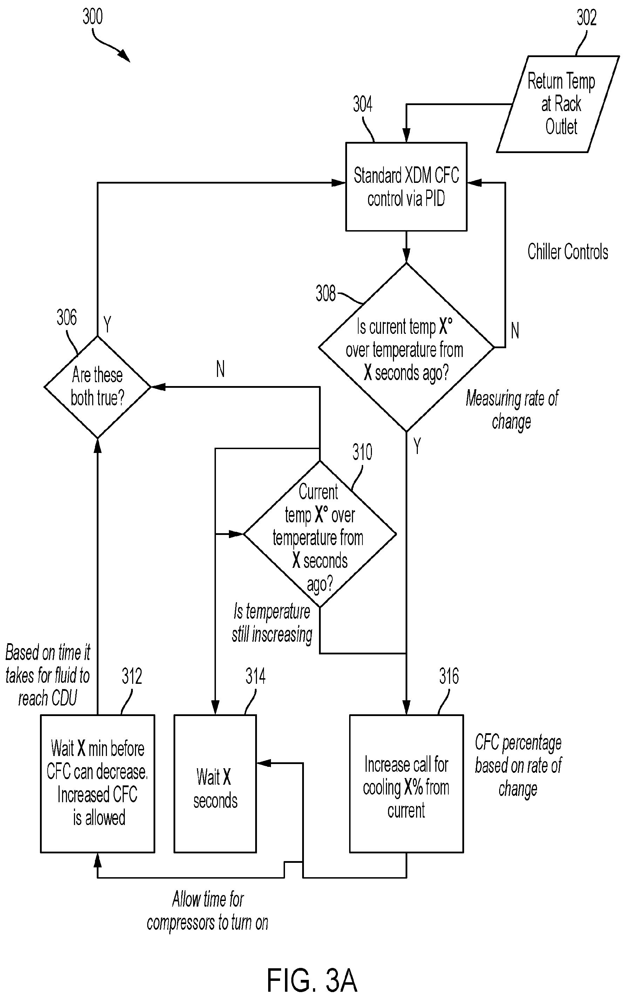

FIG. 3A is a flow diagram that illustrates a process 300 of operating the cooling system 100 for a data center when a significant use of a given server rack commences, wherein the process is described largely from a perspective of the heat rejection plant 102, according to some examples.

In block 302, return temperature readings, measured by the temperature sensor 108 that is located at the outlet of the server enclosure 112, are provided to the computing device controller 104 in response to polling requests from the computing device controller 104.

In block 304, the computing device controller 104 polls the temperature sensor 108 that is located at the outlet of the server enclosure 112 for an updated temperature reading. In some examples, the computing device controller 104 may be locally connected to the CDU 110, as illustrated in FIG. 1.

In block 302, a return temperature reading, measured by the temperature sensor 108 that is located at the outlet of the server enclosure 112, is provided to the computing device controller 104.

In block 308, the computing device controller 104 determines whether or not the recent temperature reading reflects an elevated temperature or not. If the temperature reading is not above a given threshold, or is not elevated a certain amount with respect to a previous temperature reading, then the computing device controller 104 continues to poll the temperature sensor 108 for new temperature readings. If the temperature reading is above a given threshold, or is elevated a certain amount with respect to a previous temperature reading, then the computing device controller 104 provides instructions, as illustrated in block 316, to the heat rejection plant 102 to increasing cooling capacity by *X*% with respect to the previous cooling capacity, e.g., Y%. This may also be referred to as a "call for cooling" and/or a CFC instruction, according to some examples. This instruction to increase cooling capacity by *X%* as opposed to Z%, etc. is determined based on a rate of change between previous temperature readings and the most recently received temperature reading.

In block 314, the computing device controller 104 indicates that a certain amount of time must pass before further action is taken in order to allow time for compressors to turn on. In the meantime, the computing device controller 104 continues to poll for new temperature readings, as indicated in block 310. If the new temperature reading is elevated by a certain amount with respect to past temperature readings, then the computing device controller 104 may provide another set of instructions to the heat rejection plant 102 to even further increase cooling capacity with respect to the previous instruction of *X*% increased capacity. This loop may continue, as illustrated in FIG. 3A. If, however, the new temperature reading is not elevated with respect to the past temperature readings, the computing device controller 104 may deduce that the temperature at the outlet of the server enclosure 112 has stabilized at an elevated temperature, and proceed to block 312.

In block 312, the computing device controller 104 again indicates that a certain amount of time must pass before further action is taken, based on an amount of time it takes for coolant fluid to reach the CDU 110. If, after the given passage of time, the temperature has not continued to increase, as indicated by block 306, the computing device controller 104 may then provide yet another set of instructions to the heat rejection plant 102 to begin reverting the cooling capacity back to its original capacity (e.g., ramp the cooling capacity back down by X%).

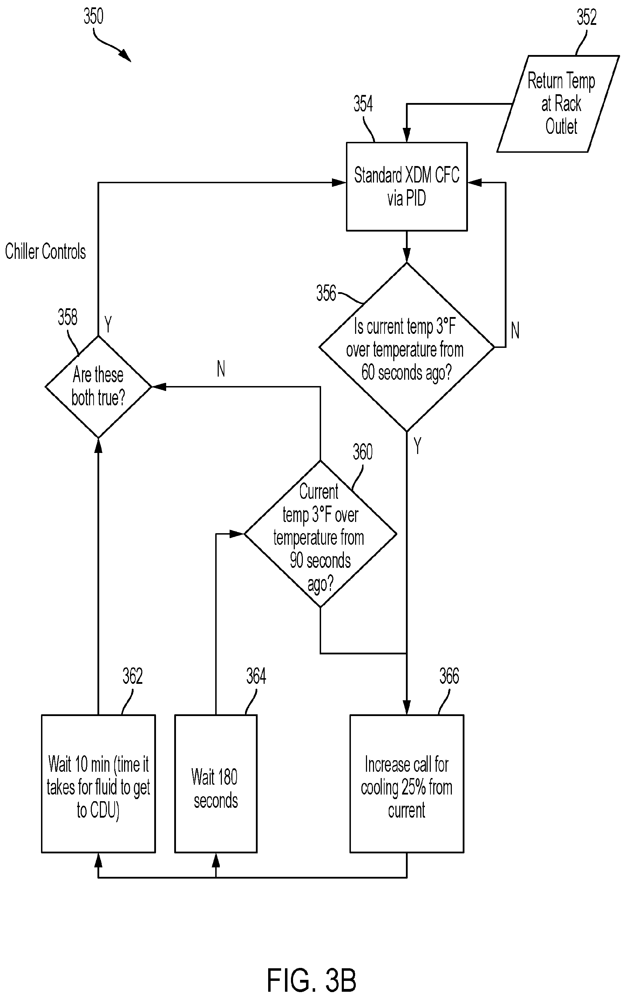

FIG. 3B follows a similar flow diagram to that which was introduced in FIG. 3A, and provides example time increments that are applied during a process 350, according to some examples.

In block 352, return temperature readings, measured by the temperature sensor 108 that is located at the outlet of the server enclosure 112, are provided to the computing device controller 104 in response to polling requests from the computing device controller 104.

In block 354, the computing device controller 104 polls the temperature sensor 108 that is located at the outlet of the server enclosure 112 for an updated temperature reading.

In block 352, a return temperature reading, measured by the temperature sensor 108 that is located at the outlet of the server enclosure 112, is provided to the computing device controller 104.

In block 358, the computing device controller 104 determines whether or not the recent temperature reading reflects an elevated temperature of 3°F higher than sixty seconds ago or not. If the temperature reading is not 3°F higher than sixty seconds ago, then the computing device controller 104 continues to poll the temperature sensor 108 for new temperature readings. If the temperature reading is at least 3°F higher than sixty seconds ago, then the computing device controller 108 provides instructions, as illustrated in block 266, to the heat rejection plant 102 to increasing cooling capacity by 25% with respect to the previous cooling capacity.

In block 364, the computing device controller 104 indicates that 180 seconds must then pass before further action is taken. In the meantime, the computing device controller 104 continues to poll for new temperature readings, as indicated in block 360. If the new temperature reading is elevated by 3°F higher than ninety seconds ago, then the computing device controller 104 may provide another set of instructions to the heat rejection plant 102 to even further increase cooling capacity with respect to the previous instruction of 25%. This loop may continue, as illustrated in FIG. 3B. If, however, the new temperature reading is not elevated with respect to the past temperature readings, the computing device controller 104 may deduce that the temperature at the outlet of the server enclosure 112 has stabilized at an elevated temperature, and proceed to block 362.

In block 362, the computing device controller 104 again indicates that ten minutes must pass before further action is taken. If, after the ten minutes, the temperature has not continued to increase, as indicated by block 356, the computing device controller 104 may then provide yet another set of instructions to the heat rejection plant 102 to begin reverting back to the original cooling capacity (e.g., ramp cooling capacity back down by 30%).

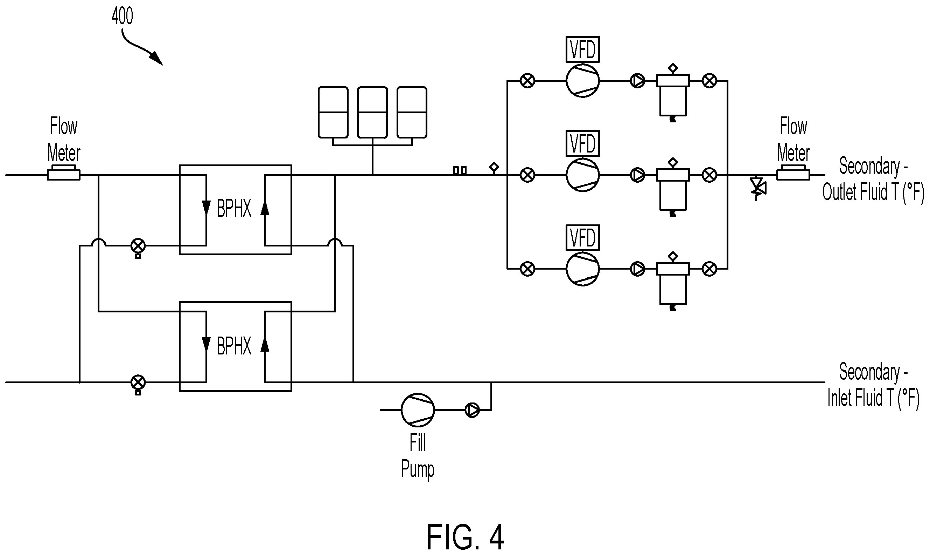

FIG. 4 is a schematic of a coolant distribution unit 400, according to some examples.

As illustrated in the figure, the secondary inlet fluid line refers to water flowing in from the server enclosure 112 to the CDU 110, and also through the buffer tank 106 according to some examples. The secondary outlet fluid line refers to water flowing out from the CDU 110 to the server enclosure 112. Additional features of the CDU 110 may include flow meters and variable frequency drives (VFDs).

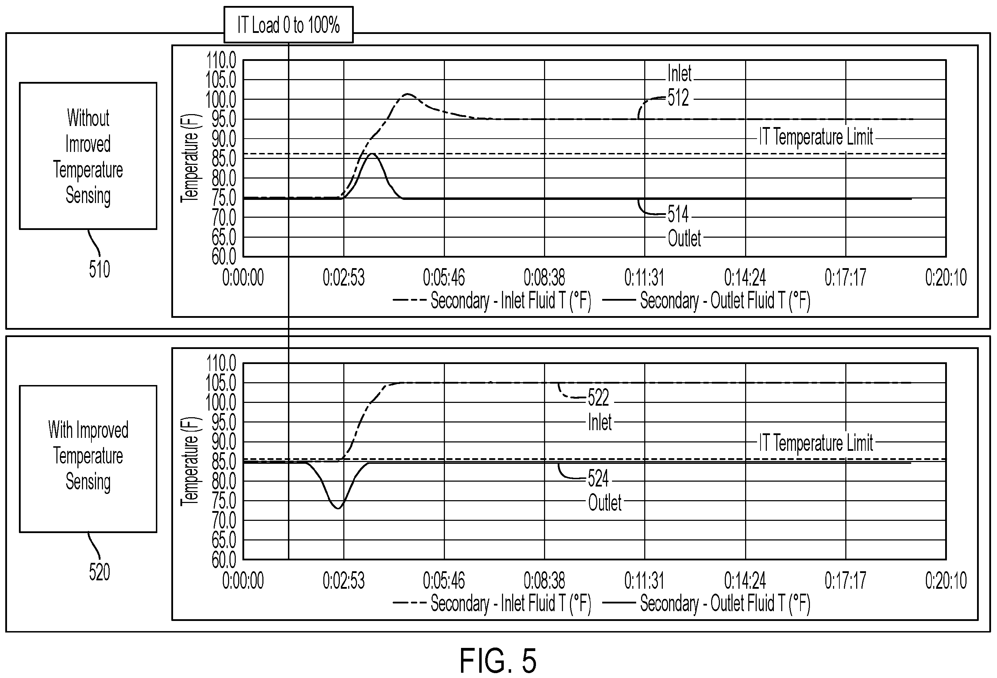

FIG. 5 illustrates inlet and outlet water temperatures from a perspective of a coolant distribution unit, according to some examples.

As shown in both plots 510 and 520, the vertical line denoted as "IT Load 0 to 100%" denotes a moment in time at which point a substantial and sudden usage of the computing resources within the server enclosure 112 begins. This also refers to the moment in time that the computing device controller 104 detects, via temperature readings from the temperature sensor 108, an increase in temperature at the outlet of the server enclosure 112 with respect to previously received temperature readings.

Plot 510 depicts the temperature of water coming into and out of the CDU 110 through time if the temperature sensor 108 were not located at the outlet of the server enclosure 112 (e.g., it is instead located at the CDU 110, etc.). As illustrated in the figure, inlet 512 and outlet 514 read 75°F prior to "IT Load 0 to 100%." Inlet 512 reflects an increase in temperature which then stabilizes at 95°F while outlet 514 increases up to the IT Temperature Limit of 85°F before decreasing back down to 75°F. If the temperature sensor 108 is not located at the outlet of the server enclosure 112, then outlet 514 reflects a temperature set point of approximately 75°F in order to provide a buffer temperature range between the set point and the IT Temperature Limit, also denoted in plot 510. This buffer temperature range is larger than that of plot 520, described in the following paragraph.

Plot 520 depicts the temperature of water coming into and out of CDU 110 through time when temperature sensor 108 is located at the outlet of server enclosure 112. As illustrated in the figure, inlet 522 and outlet 524 read 85°F prior to "IT Load 0 to 100%." Inlet 522 reflects an increase in temperature which then stabilizes at 105°F while outlet 524 decreases to below 75°F before increasing back up to 85°F. If temperature sensor 108 is located at the outlet of server enclosure 112, then outlet 524 reflects a temperature set point of approximately 84°F in order to provide a buffer temperature range between the set point and the IT Temperature Limit, also denoted in plot 520. However, this buffer temperature range is smaller than that of plot 510, since locating temperature sensor 108 enables a faster response time for the cooling system described herein.

The foregoing description is merely illustrative in nature and is in no way intended to limit the disclosure, its application, or uses. The broad teachings of the disclosure can be implemented in a variety of forms. Therefore, while this disclosure includes particular examples, the true scope of the disclosure should not be so limited since other modifications will become apparent upon a study of the drawings, the specification, and the following claims. It should be understood that one or more steps within a method may be executed in different order (or concurrently) without altering the principles of the present disclosure. Further, although each of the examples is described above as having certain features, any one or more of those features described with respect to any example of the disclosure can be implemented in and/or combined with features of any of the other examples, even if that combination is not explicitly described. In other words, the described examples are not mutually exclusive, and permutations of one or more examples with one another remain within the scope of this disclosure.

Spatial and functional relationships between elements (for example, between modules, circuit elements, semiconductor layers, etc.) are described using various terms, including "connected," "engaged," "coupled," "adjacent," "next to," "on top of," "above," "below," and "disposed." Unless explicitly described as being "direct," when a relationship between first and second elements is described in the above disclosure, that relationship can be a direct relationship where no other intervening elements are present between the first and second elements, but can also be an indirect relationship where one or more intervening elements are present (either spatially or functionally) between the first and second elements. As used herein, the phrase at least one of A, B, and C should be construed to mean a logical (A OR B OR C), using a non-exclusive logical OR, and should not be construed to mean "at least one of A, at least one of B, and at least one of C."

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

In the figures, the direction of an arrow, as indicated by the arrowhead, generally demonstrates the flow of information (such as data or instructions) that is of interest to the illustration. For example, when element A and element B exchange a variety of information but information transmitted from element A to element B is relevant to the illustration, the arrow may point from element A to element B. This unidirectional arrow does not imply that no other information is transmitted from element B to element A. Further, for information sent from element A to element B, element B may send requests for, or receipt acknowledgements of, the information to element A.

The apparatuses and methods described in this application may be partially or fully implemented by a special purpose computer created by configuring a general purpose computer to execute one or more particular functions embodied in computer programs. The functional blocks, flowchart components, and other elements described above serve as software specifications, which can be translated into the computer programs by the routine work of a skilled technician or programmer.

Further examples are set out in the items below:
1. A cooling system, comprising:
   a coolant distribution unit, configured to cycle a coolant to an inlet of a server enclosure;
   a heat rejection plant, configured to cycle the coolant to the coolant distribution unit;
   the server enclosure, comprising a plurality of servers;
   a temperature sensor, located at an outlet of the server enclosure, and configured to periodically perform a temperature reading at the outlet of the server enclosure; and
   a computing device configured to:
      receive the periodic temperature readings from the temperature sensor;
      detect that a recent temperature reading is outside of a temperature range allocated for the server enclosure;
      provide a first alert to the coolant distribution unit; and
      cause the heat rejection plant to begin a ramp up sequence.
2. The cooling system of item 1, wherein the first alert to the coolant distribution unit comprises an indication to open valves to an updated position with respect to a previous position of the valves.
3. The cooling system of item 2, wherein the computing device is further configured to:
   receive one or more additional temperature readings from the temperature sensor; detect that a given one of the additional temperature readings indicates that temperature at the outlet of the server enclosure has stabilized at an elevated temperature; and
   provide an indication to the coolant distribution unit to maintain the updated position of the valves.
4. The cooling system of item 3, wherein the computing device is further configured to:
   receive one or more further temperature readings from the temperature sensor;
   detect that a given one of the further temperature readings is within the temperature range allocated for the server enclosure;
   provide a second alert to the coolant distribution unit to close the valves a given percentage with respect to the updated position; and
   cause the heat rejection plant to be deactivated.
5. The cooling system of any one of the preceding items, further comprising:
   a buffer tank, wherein the buffer tank is located in between the outlet of the server enclosure and the coolant distribution unit.
6. The cooling system of item 5, wherein the computing device is further configured to compute usage of the buffer tank prior to providing the first alert to the coolant distribution unit.
7. The cooling system of any one of the preceding items, wherein the heat rejection plant is an indoor chiller.
8. The cooling system of any one of the preceding items, wherein the heat rejection plant is a dry cooler.
9. The cooling system of any one of the preceding items, wherein the heat rejection plant is a cooling tower.
10. A method for controlling a cooling system, comprising:
   receiving temperature readings from a temperature sensor that is located at an outlet of a server enclosure;
   determining, based on a given one of the temperature readings, that temperature at the outlet of the server enclosure is outside of a temperature range allocated for the server enclosure;
   sending a first alert to a coolant distribution unit to open valves to an updated position with respect to a previous position of the valves; and
   sending a second alert to a heat rejection plant to begin a ramp up sequence to provide coolant to the coolant distribution unit.
11. The method of item 10, comprising:
   receiving additional temperature readings from the temperature sensor;
   determining that the temperature at the outlet of the server enclosure has stabilized at an elevated temperature; and
   sending a third alert to the coolant distribution unit to maintain the updated position of the valves.
12. The method of item 11, comprising:
   subsequent to waiting a fixed amount of time after determining that the temperature at the outlet of the server enclosure has stabilized,
   sending a fourth alert to the coolant distribution unit to close the valves back to the previous position of the valves; and
   sending a fifth alert to the heat rejection plant to begin a ramp down sequence.
Further examples are set out in the clauses below:
1. A cooling system, comprising:
   a coolant distribution unit, configured to cycle a coolant to an inlet of a server enclosure;
   a heat rejection plant, configured to cycle the coolant to the coolant distribution unit;
   the server enclosure, comprising a plurality of computing resources;
   a temperature sensor, located at an outlet of the server enclosure, and configured to periodically perform a temperature reading at the outlet of the server enclosure; and
   a computing device controller configured to:
      receive the temperature readings from the temperature sensor;
      detect that a recent temperature reading is outside of a temperature range allocated for the server enclosure;
      provide a first alert to the coolant distribution unit; and
      cause the heat rejection plant to begin a ramp up sequence.
2. The cooling system of clause 1, wherein the first alert to the coolant distribution unit comprises an indication to open valves to an updated position with respect to a previous position of the valves.
3. The cooling system of clause 2, wherein the computing device controller is further configured to:
   receive additional temperature readings from the temperature sensor over a second period of time;
   detect that a given one of the additional temperature readings indicates that temperature at the outlet of the server enclosure has stabilized at an elevated temperature; and
   provide an indication to the coolant distribution unit to maintain the updated position of the valves.
4. The cooling system of clause 3, wherein the computing device controller is further configured to:
   receive, subsequent to the reception of the additional temperature readings, further temperature readings from the temperature sensor over a third period of time;
   detect that a given one of the further temperature readings is within the temperature range allocated for the server enclosure;
   provide a second alert to the coolant distribution unit to close the valves a given percentage with respect to the updated position; and
   cause the heat rejection plant to be deactivated.
5. The cooling system of any one of the preceding clauses, wherein, to detect that the recent temperature reading is outside of the temperature range allocated for the server enclosure, the computing device controller is configured to:
   compare the recent temperature reading to stored information pertaining to a range of acceptable temperatures that the server enclosure and the plurality of computing resources inside the server enclosure are configured to operate within; and
   determine that the recent temperature reading is outside of that range.
6. The cooling system of any one of the preceding clauses, further comprising a buffer tank, wherein the buffer tank is located in between the outlet of the server enclosure and the coolant distribution unit.
7. The cooling system of clause 6, wherein the buffer tank is made of metal and is coated with an anti-condensate insulation.
8. The cooling system of clause 6, wherein the computing device controller is further configured to compute usage of the buffer tank prior to providing the first alert to the coolant distribution unit.
9. The cooling system of any one of the preceding clauses, wherein the heat rejection plant is an indoor chiller.
10. The cooling system of any one of the preceding clauses, wherein the heat rejection plant is a dry cooler.
11. The cooling system of any one of the preceding clauses, wherein the heat rejection plant is a cooling tower.
12. A method for controlling a cooling system, comprising:
   receiving temperature readings from a temperature sensor that is located at an outlet of a server enclosure;
   determining, based on a given one of the temperature readings, that temperature at the outlet of the server enclosure is outside of a temperature range allocated for the server enclosure;
   sending a first alert to a coolant distribution unit to open valves to an updated position with respect to a previous position of the valves; and
   sending a second alert to a heat rejection plant to begin a ramp up sequence to provide coolant to the coolant distribution unit.
13. The method of clause 12, comprising:
   receiving additional temperature readings from the temperature sensor;
   determining that the temperature at the outlet of the server enclosure has stabilized at an elevated temperature; and
   sending a third alert to the coolant distribution unit to maintain the updated position of the valves.
14. The method of clause 13, comprising:
   subsequent to waiting a fixed amount of time after determining that the temperature at the outlet of the server enclosure has stabilized,
   sending a fourth alert to the coolant distribution unit to close the valves back to the previous position of the valves; and
   sending a fifth alert to the heat rejection plant to begin a ramp down sequence.
15. A cooling system, comprising:
   a coolant distribution unit, configured to cycle a coolant to an inlet of a server enclosure;
   the server enclosure, comprising a plurality of computing resources;
   a temperature sensor, located at an outlet of the server enclosure, and configured to periodically perform a temperature reading at the outlet of the server enclosure; and
   a computing device controller configured to:
      receive temperature readings from the temperature sensor;
      determine, based on a given one of the temperature readings, that temperature at the outlet of the server enclosure is outside of a temperature range allocated for the server enclosure;
      send a first alert to the coolant distribution unit to open valves to an updated position with respect to a previous position of the valves; and
      send a second alert to a heat rejection plant that is coupled to the coolant distribution unit to begin a ramp up sequence to provide coolant to the coolant distribution unit.
16. The cooling system of clause 15, wherein the computing device controller is further configured to:
   receive additional temperature readings from the temperature sensor;
   determine that the temperature at the outlet of the server enclosure has stabilized at an elevated temperature; and
   send a third alert to the coolant distribution unit to maintain the updated position of the valves.
17. The cooling system of clause 16, wherein the computing device controller is further configured to:
   subsequent to waiting a fixed amount of time after determining that the temperature at the outlet of the server enclosure has stabilized,
   send a fourth alert to the coolant distribution unit to close the valves back to the previous position of the valves; and
   send a fifth alert to the heat rejection plant to begin a ramp down sequence.
18. The cooling system of any one of clauses 15-17, wherein, to determine that the temperature at the outlet of the server enclosure is outside of the temperature range, the computing device controller is configured to:
   compare the given one of the temperature readings to stored information pertaining to a range of acceptable temperatures that the server enclosure and the plurality of computing resources inside the server enclosure are configured to operate within; and
   determine that the given one of the temperature reading is outside of that range.
19. The cooling system of any one of clauses 15-18, further comprising a buffer tank, wherein the buffer tank is located in between the outlet of the server enclosure and the coolant distribution unit.
20. The cooling system of clause 19, wherein the computing device controller is further configured to compute usage of the buffer tank prior to the sending of the first alert to the coolant distribution unit.

## Claims

1. A cooling system, comprising:
a coolant distribution unit, configured to cycle a coolant to an inlet of a server enclosure;
a heat rejection plant, configured to cycle the coolant to the coolant distribution unit;
the server enclosure, comprising a plurality of computing resources;
a temperature sensor, located at an outlet of the server enclosure, and configured to periodically perform a temperature reading at the outlet of the server enclosure; and
a computing device controller configured to:
receive the temperature readings from the temperature sensor;
detect that a recent temperature reading is outside of a temperature range allocated for the server enclosure;
provide a first alert to the coolant distribution unit; and
cause the heat rejection plant to begin a ramp up sequence.

2. The cooling system of claim 1, wherein the first alert to the coolant distribution unit comprises an indication to open valves to an updated position with respect to a previous position of the valves.

3. The cooling system of claim 2, wherein the computing device controller is further configured to:
receive additional temperature readings from the temperature sensor over a second period of time;
detect that a given one of the additional temperature readings indicates that temperature at the outlet of the server enclosure has stabilized at an elevated temperature; and
provide an indication to the coolant distribution unit to maintain the updated position of the valves; and optionally
wherein the computing device controller is further configured to:
receive, subsequent to the reception of the additional temperature readings, further temperature readings from the temperature sensor over a third period of time;
detect that a given one of the further temperature readings is within the temperature range allocated for the server enclosure;
provide a second alert to the coolant distribution unit to close the valves a given percentage with respect to the updated position; and
cause the heat rejection plant to be deactivated.

4. The cooling system of any one of the preceding claims, wherein, to detect that the recent temperature reading is outside of the temperature range allocated for the server enclosure, the computing device controller is configured to:
compare the recent temperature reading to stored information pertaining to a range of acceptable temperatures that the server enclosure and the plurality of computing resources inside the server enclosure are configured to operate within; and
determine that the recent temperature reading is outside of that range.

5. The cooling system of any one of the preceding claims, further comprising a buffer tank, wherein the buffer tank is located in between the outlet of the server enclosure and the coolant distribution unit.

6. The cooling system of claim 5, wherein the buffer tank is made of metal and is coated with an anti-condensate insulation; or optionally

7. The cooling system of claim 5, wherein the computing device controller is further configured to compute usage of the buffer tank prior to providing the first alert to the coolant distribution unit.

8. The cooling system of any one of the preceding claims, wherein the heat rejection plant is an indoor chiller; or optionally
wherein the heat rejection plant is a dry cooler; or optionally
wherein the heat rejection plant is a cooling tower.

9. A method for controlling a cooling system, comprising:
receiving temperature readings from a temperature sensor that is located at an outlet of a server enclosure;
determining, based on a given one of the temperature readings, that temperature at the outlet of the server enclosure is outside of a temperature range allocated for the server enclosure;
sending a first alert to a coolant distribution unit to open valves to an updated position with respect to a previous position of the valves; and
sending a second alert to a heat rejection plant to begin a ramp up sequence to provide coolant to the coolant distribution unit.

10. The method of claim 9, comprising:
receiving additional temperature readings from the temperature sensor;
determining that the temperature at the outlet of the server enclosure has stabilized at an elevated temperature; and
sending a third alert to the coolant distribution unit to maintain the updated position of the valves.

11. The method of claim 10, comprising:
subsequent to waiting a fixed amount of time after determining that the temperature at the outlet of the server enclosure has stabilized,
sending a fourth alert to the coolant distribution unit to close the valves back to the previous position of the valves; and
sending a fifth alert to the heat rejection plant to begin a ramp down sequence.

12. The cooling system of claim 1, wherein the
computing device controller is further configured to:
determine, based on a given one of the temperature readings, that temperature at the outlet of the server enclosure is outside of a temperature range allocated for the server enclosure,
wherein the first alert provided to the coolant distribution unit is configured to open valves to an updated position with respect to a previous position of the valves; and
wherein the computing device controller is further configured to send a second alert to the heat rejection plant to cause the heat rejection plant to begin a ramp up sequence to begin a ramp up sequence to provide coolant to the coolant distribution unit; the heat rejection plant being coupled to the coolant distribution unit

13. The cooling system of claim 12, wherein the computing device controller is further configured to:
receive additional temperature readings from the temperature sensor;
determine that the temperature at the outlet of the server enclosure has stabilized at an elevated temperature; and
send a third alert to the coolant distribution unit to maintain the updated position of the
valves; and optionally
wherein the computing device controller is further configured to:
subsequent to waiting a fixed amount of time after determining that the temperature at the outlet of the server enclosure has stabilized,
send a fourth alert to the coolant distribution unit to close the valves back to the previous position of the valves; and
send a fifth alert to the heat rejection plant to begin a ramp down sequence.

14. The cooling system of claim 12, wherein, to determine that the temperature at
the outlet of the server enclosure is outside of the temperature range, the computing device controller is configured to:
compare the given one of the temperature readings to stored information pertaining to a range of acceptable temperatures that the server enclosure and the plurality of computing resources inside the server enclosure are configured to operate within; and
determine that the given one of the temperature reading is outside of that range.

15. The cooling system of claim 12, further comprising a buffer tank, wherein the buffer tank is located in between the outlet of the server enclosure and the coolant distribution unit; and optionally
wherein the computing device controller is further configured to compute usage of the buffer tank prior to the sending of the first alert to the coolant distribution unit.
